# FASCICULE DE BREVET EUROPEEN

(11) **EP 2 002 474 B1**
(45) Date de publication et mention de la délivrance du brevet: **21.09.2016**
(21) Numéro de dépôt: 07731215.5
(22) Date de dépôt: 28.03.2007
(51) Int. Cl.: H01L 21/762

(54) **PROCEDE DE DETACHEMENT D'UN FILM MINCE PAR FUSION DE PRECIPITES**
VERFAHREN ZUM ABLÖSEN EINES DÜNNFILMS DURCH SCHMELZNIEDERSCHLÄGE
METHOD OF DETACHING A THIN FILM BY MELTING PRECIPITATES

(30) Priorité: 29.03.2006 FR 0651088
(43) Date de publication de la demande: 17.12.2008
(73) Titulaire: Commissariat à l'Énergie Atomique et aux Énergies Alternatives, 75015 Paris (FR); Soitec, 38190 Bernin (FR)
(72) Inventeur: TAUZIN, Aurélie, F-38120 Saint Egreve (FR); FAURE, Bruce, 75011 Paris (FR); GARNIER, Arnaud, F-38000 Grenoble (FR)
(74) Mandataire: Colombo, Michel
(86) Numéro de dépôt international: PCT/FR2007/000534
(87) Numéro de publication internationale: WO 2007/110515

(56) Documents cités:
- JP-A- 58 031 519
- ALMEIDA ET AL: "Bond formation in ion beam synthesised amorphous gallium nitride" THIN SOLID FILMS, ELSEVIER-SEQUOIA S.A. LAUSANNE, CH, vol. 343-344, avril 1999 (1999-04), pages 632-636, XP005021022 ISSN: 0040-6090
- MATSUO J ET AL: "Abnormal solid solution and activation behavior in Ga-implanted Si(100)" APPLIED PHYSICS LETTERS USA, vol. 51, no. 24, 14 décembre 1987 (1987-12-14), pages 2037-2039, XP002404174 ISSN: 0003-6951
- JONES K S ET AL: "Enhanced elimination of implantation damage upon exceeding the solid solubility" JOURNAL OF APPLIED PHYSICS USA, vol. 62, no. 10, 15 novembre 1987 (1987-11-15), pages 4114-4117, XP002404175 ISSN: 0021-8979 cité dans la demande

## Description

### Etat de la technique et problème technique

L'invention concerne un procédé de détachement d'un film mince par rapport à un substrat mettant en oeuvre une fusion de précipités.

On connaît déjà, par le document US-5 374 564 (Bruel), un procédé de fabrication de films minces de matériaux semi-conducteurs comprenant les étapes suivantes :
1. bombardement d'une face d'un substrat avec des ions, afin d'implanter ces ions en concentration suffisante pour créer une couche de microbulles gazeuses formant des microcavités définissant une couche de fragilisation ;
2. mise en contact intime de cette face du substrat avec un raidisseur ; et
3. séparation au niveau de la couche de microcavités, par l'application d'un traitement thermique.

Dans ce document, les ions implantés à l'étape 1 sont avantageusement des ions hydrogène, mais il est indiqué qu'on peut aussi utiliser des gaz rares. Quant au substrat il est, dans les exemples considérés, formé de silicium, mais il est indiqué qu'il peut aussi s'agir de semi-conducteurs du groupe IV de la Table de Mendeleiev, tels que le germanium, le carbure de silicium ou les alliages silicium-germanium.

Dans ce document, la séparation est obtenue au moyen d'un traitement thermique, mais il a ensuite été proposé, dans des variantes du procédé, de provoquer la séparation par application, en complément ou non d'un tel traitement thermique, d'une contrainte de détachement (par exemple, l'insertion d'une lame entre les deux substrats et/ou encore des efforts de traction et/ou de flexion et/ou de cisaillement, et/ou encore l'application d'ultrasons ou de micro-ondes de puissance et de fréquence judicieusement choisies). On peut se référer notamment au document US - 6 020 252 (Aspar et al.) et à ses perfectionnements.

Cette technologie a été testée sur des substrats formés d'autres matériaux, avec des implantations d'autres ions, légers ou non.

Les défauts ainsi créés ont été désignés par diverses expressions ; on a parlé non seulement de microcavités gazeuses, mais aussi de défauts plus plats (parfois désignés sous la dénomination de microplatelets).

De manière générale, cette technologie met en oeuvre des microcavités gazeuses localisées dans le substrat, à une profondeur à laquelle on veut « découper » une couche mince.

Toutefois, le principe de bombarder un substrat avec des ions est aussi connu pour d'autres raisons. C'est ainsi qu'il est connu de mettre en oeuvre de tels bombardements, dans le même domaine des semi-conducteurs et de la micro-électronique, pour réaliser des dopages, avec des efficacités d'autant plus élevées que les doses d'implantation sont importantes.

A ce propos, diverses études ont été menées en vue de bien caractériser les conséquences de tels dopages, c'est-à-dire de caractériser les défauts cristallins ou les inclusions qui peuvent résulter de ces dopages, et déterminer, dans la mesure du possible, comment éviter ou au moins minimiser ces détériorations.

C'est ainsi que, notamment, S. K. JONES et al., dans l'article « Enhanced élimination of implantation damage upon exceeding the solid solubility » paru dans Journal of Applied Physics, vol. 62, n° 10, 15 november 1987, pp 4114-4117, se sont intéressés à l'implantation d'ions gallium ou phosphore, voire d'arsenic, dans divers substrats, dont du silicium, et ont conclu que, lorsque le pic de concentration de l'impureté de dopage dépasse sa solubilité dans le silicium à la température de recuit, il y a une élimination améliorée des défauts de type Il (notamment constitués de boucles de dislocations) lorsque les précipités, formés en raison de l'excès de l'espèce implantée, se dissolvent. Plus précisément, ils ont notamment relevé, que l'implantation de l'ion gallium à 100 keV à une dose de 10¹⁵/cm² dans du silicium entraîne une amorphisation de ce dernier, avec un pic de concentration du gallium qui est supérieur à la solubilité du gallium dans le silicium aussi bien à 900 °C qu'à 1100 °C (la limite de solubilité du gallium dans le silicium est à peine de l'ordre de 2.10¹⁹ /cm³ à 900°C ou 5.10¹⁹/cm³ à 1100°C); mais un traitement de recuit de 16 h à 550 °C conduit à une recristallisation de la phase amorphe et, si l'on recuit ensuite à 900 °C pendant 1 h, il y a formation de précipités, lesquels se dissolvent si la température ou la durée augmente (par exemple 8 h à 900 °C) en faisant disparaître les défauts de type II.

Par ailleurs, J. MATSUO et al. ont, dans l'article « Abnormal solid solution and activation behavior in Ga-implanted Si (100) », paru dans Applied Physics Letter, Vol 51, n° 24, 14 december 1987, pp 2037-2039, étudié les effets du recuit sur du silicium dopé avec du gallium, et ont conclu que le comportement au recuit des substrats implantés avec du gallium est différent de celui observé avec d'autres dopants. Plus précisément, ils ont relevé que l'implantation du gallium à 70 keV et 10¹⁵/cm² dans le silicium, suivie d'un recuit pendant 10 s à 600 °C, entraîne une amorphisation du silicium, que le pic de concentration de gallium (2.10²⁰/cm³) à 70 keV est 10 fois supérieur à la limite de solubilité du gallium dans le silicium à 900 °C, et qu'un recuit à 1100 °C pendant 10 s fait précipiter le gallium.

Parmi les études effectuées pour bien comprendre les phénomènes de formation des précipités de gallium, on peut citer celle de S. DHARA et al., dans « Mechanism of nanoblister formation in Ga+ self-ion implanted GaN nanowires », paru dans Applied Physics Letters, vol 86, n° 20, pp203119-1 à 3, septembre 2005 ; les auteurs ont constaté que l'implantation de gallium à 50 keV et 2.10¹⁶/cm² dans des nano-fils de GaN entraîne l'apparition de précipités de gallium de 50 nm à 100 nm de diamètre, et qu'il y avait un déficit d'atomes N et une accumulation de Ga autour de la région de vides.

Il est à noter que le gallium peut être utilisé, dans le domaine des semi-conducteurs et de la micro-électronique, pour d'autres applications que celles du dopage, à savoir la synthèse de certains matériaux, notamment.

C'est ainsi que M. K. SUNKARA et al., dans « Bulk synthesis of silicon nanowires using a low-temperature vapor-liqui-solid solution », paru dans Applied Physics Letters, vol. 79, n° 10, septembre 2001, pp 1546-1548, ont présenté un procédé de synthèse vapeur-liquide-solide à basse température qui utilise des solvants métalliques solides à basse solubilité pour le silicium et d'autres matériaux semi-conducteurs. Ils ont notamment proposé de faire la synthèse de nanofils de silicium en utilisant du gallium en tant que solvant, en tirant profit d'un diagramme de phase Ga-Si qui montre qu'il existe un composé eutectique, Ga₍₁₋ₓ₎Siₓ avec x=5.10⁻⁸ %, qui a une température de fusion de 29.8 °C (égale à celle du gallium pur).

### Définition de l'invention

L'invention a pour objet de tirer profit des modifications structurales constatées dans diverses techniques d'implantations, autres que des vides ou cavités gazeuses, pour permettre un détachement de films minces, sans avoir à générer des microbulles ou microcavités ou microplatelets, en pouvant notamment utiliser, aussi bien pour le substrat que pour les ions implantés, des espèces qui ne forment pas des molécules gazeuses. Elle vise en particulier à tirer profit d'une formation de précipités appropriés.

Elle est fondée sur le fait que, en choisissant judicieusement, pour un substrat donné, l'espèce implantée ainsi que les conditions d'implantation, de même que celles d'éventuels traitements thermiques ultérieurs, certaines des inclusions et précipités formés en conséquence de l'implantation d'ions dans le substrat ont une température de fusion comprise dans la gamme des températures auxquelles il est habituel d'appliquer un traitement tel qu'un recuit (typiquement entre 50°C et 1100°C), de sorte qu'un détachement peut être réalisé à un moment où ces inclusions ou précipités sont en phase liquide, et ont vis-à-vis du substrat un comportement qui se rapproche de celui des microbulles ou des microcavités.

C'est ainsi que l'invention propose un procédé de fabrication d'un film mince à partir d'un substrat comportant les étapes suivantes :
(1) implantation dans le substrat d'ions d'une espèce non gazeuse, cette espèce et les conditions d'implantation étant choisies, en fonction du matériau du substrat, en sorte de permettre la formation de précipités formés d'atomes implantés et éventuellement d'atomes du substrat et confinés en profondeur et répartis au sein d'une couche, ces précipités étant en une phase solide ayant une température de fusion inférieure à celle du substrat;
(2) mise en contact intime de la face du substrat par laquelle les ions sont implantés avec un raidisseur ; et
(3) passage des précipités de la phase solide à la phase liquide et détachement d'un film mince par rupture du substrat au niveau de la couche de précipités par l'application d'une sollicitation de détachement dans des conditions où les précipités sont en phase liquide.

Ainsi, selon ce procédé, et contrairement au procédé décrit dans le document US-5 374 564, les ions implantés à l'étape 1 ne sont pas des espèces gazeuses : les ions implantés sont tout type d'ions non gazeux, propres à former dans le substrat, après implantation, à eux seuls ou conjointement avec l'espèce (ou une espèce) contenue dans le substrat, des précipités ayant une température de fusion comprise dans la gamme des températures auxquelles il est habituel d'appliquer des traitements aux substrats, films minces ou composants utilisés en micro-électronique.

On peut noter que, dans les documents précités de JONES et al. et de MATSUO et al., la présence de précipités de gallium n'est souhaitée que pour en provoquer la dissolution et ainsi faire disparaître les défauts résultant de l'implantation. Il n'y est pas relevé que ces précipités ont une faible température de fusion ni, a fortiori, que l'on peut en profiter pour provoquer un détachement à une température où ces précipités sont liquides.

De même, l'article précité de DHARA et al. qui a détecté la formation de précipités de gallium suite à une implantation de gallium dans du GaN, il ne contient aucune suggestion pour tirer profit de ces précipités ; on peut noter que ce document mentionne comme étant un problème le fait que le gallium fond à 302.8 K, de sorte que ce document ne saurait être considéré comme contenant la moindre reconnaissance de ce qu'on peut tirer profit des précipités pour provoquer un détachement dans des conditions dans lesquelles ils ne sont plus solides.

En ce qui concerne le document de SUNKARA et al., on a vu qu'il proposait de tirer profit d'un eutectique Ga-Si à l'état liquide, mais ne se préoccupait que de réaliser une synthèse de silicium, indépendamment de toute idée d'implantation en vue d'un détachement.

Diverses caractéristiques avantageuses, éventuellement combinées, peuvent être mentionnées à propos du procédé précité :
- l'implantation des ions, en pratique par bombardement, est de préférence réalisée à une température inférieure à la température de fusion des précipités, ce qui peut permettre notamment que les précipités commencent à se former en phase solide,
- la température de fusion des précipités est avantageusement supérieure à la température ambiante, ce qui garantit que, à la température ambiante, les précipités sont en phase solide, ce qui minimise les risques de séparation intempestive,
- l'implantation, en principe par bombardement, peut être effectuée sensiblement à la température ambiante, ce qui correspond à des conditions particulièrement intéressantes du point de vue énergétique,
- le détachement peut être réalisé après élévation de la température du substrat au-dessus de la température de fusion des précipités, ce qui implique que les précipités sont normalement en phase solide et ne passent en phase liquide qu'au moment où cela est utile ; ce détachement est par exemple réalisé à une température d'au moins 15 °C au dessus de la température de fusion des précipités, ce qui contribue à assurer que tous les précipités sont en phase liquide, quels que soient leurs emplacements et leur tailles,
- le détachement peut être précédé d'une pluralité de cycles consistant à faire varier la température du substrat contenant les précipités de part et d'autre de la température de fusion de ceux-ci, ce qui contribue à accroître la fragilisation locale de la couche dans laquelle les précipités sont confinés, du fait par exemple du changement de volume associé aux changements de phases successifs ; à titre d'exemple la pluralité de cycles comporte de l'ordre d'une dizaine de cycles, voire plus, ce qui implique une fragilisation très sensible ; lorsque la température de fusion est supérieure à la température ambiante, cette pluralité de cycles peut consister à faire varier la température du substrat de la température ambiante entre une température supérieure à la température de fusion,
- la température de fusion des précipités peut être choisie supérieure à la température ambiante et inférieure à 200 °C, ce qui est généralement considéré comme une température basse ; pour ce faire, les ions sont avantageusement choisis au sein du groupe comportant le césium, le gallium, le rubidium, le potassium, le sodium, l'indium et le lithium (cette liste ne prétend toutefois pas être exhaustive, car de nombreux autres précipités peuvent être obtenus par implantation tout en ayant une température de fusion située dans la plage considérée) ; dans le cas où l'on souhaite une température de fusion des précipités supérieure à l'ambiante mais inférieure à 100 °C, ce qui est intéressant du point de vue énergétique les ions sont avantageusement choisis au sein du sous-groupe comportant le césium, le gallium, le rubidium, le potassium et le sodium (cette liste n'est pas non plus exhaustive, car d'autres précipités peuvent être obtenus par implantation tout en ayant une température de fusion située dans la plage considérée) ; on peut même choisir une température de fusion des précipités supérieure à la température ambiante mais inférieure à 50 °C, ce qui n'implique que des variations très modérées de température, auquel cas les ions sont avantageusement choisis au sein du sous-groupe comportant le césium et le gallium (cette liste n'est pas exhaustive puisque d'autres précipités peuvent être trouvés avec une température de fusion se situant dans cette plage,
- les ions sont avantageusement du gallium, ce qui correspond à un cas pratique d'intérêt particulier, d'autant que sa température de fusion est particulièrement basse,
- le substrat peut constituer une pièce massive, telle qu'une plaquette ; en variante, le substrat peut n'être qu'une couche portée par un support, par exemple appelé substrat porteur, au sein d'une pièce (telle qu'une plaquette) formée de plusieurs couches superposées, en pratique en matériaux différents (dans ce cas, dans le cadre de l'invention, on désigne par substrat la couche dans laquelle s'effectue la formation des précipités ; le plus souvent, mais pas nécessairement, cette couche appelée « substrat » est la couche supérieure de cette pièce multicouche, éventuellement recouverte d'une couche beaucoup plus fine, par exemple en oxyde),

- le substrat (donc au moins la portion de la pièce précitée où s'effectue la formation des précipités) est avantageusement en un matériau cristallin (monocristallin, voire polycristallin),
- le substrat (donc au moins la portion de la pièce précitée où s'effectue la formation des précipités) est avantageusement en un matériau semi-conducteur
- le substrat est avantageusement en silicium, ce qui correspond aussi à un cas pratique de grande importance ; toutefois, le substrat peut aussi être plus généralement être choisi en un ou plusieurs matériaux du groupe IV du tableau de Mendeléiev,
- lorsque les ions sont des ions gallium implantés dans du silicium, ils sont avantageusement implantés dans le substrat en silicium avec une énergie d'au moins environ 100 keV, avec une dose d'au moins 10¹⁵ /cm²,
- en variante, le substrat peut être en nitrure de gallium, ce qui est également un cas de grande importance pratique ; plus généralement, le substrat peut aussi être choisi en matériaux des groupes III-V du tableau de Mendeléiev, AsGa et InP notamment, ou en un matériau du groupe III-N (GaN, InN, AIN par exemple ; le substrat peut aussi, selon encore une autre variante, être choisi parmi les matériaux du groupe II-VI tels que ZnO ou ZnSe, par exemple,
- lorsque les ions sont des ions de gallium implantés dans un substrat de nitrure de gallium, ces ions sont avantageusement implantés avec une énergie d'au moins environ 50 keV, avec une dose d'au moins 10¹⁵ /cm²,
- les précipités peuvent être essentiellement constitués de l'espèce implantée dans le substrat, ce qui contribue à minimiser les dégradations du substrat en dehors de la couche ; en variante, lorsqu'ils ne sont pas uniquement formés d'ions implantés, ces précipités contiennent, en plus de l'espèce implantée, une espèce contenue dans le substrat ; c'est notamment le cas de l'eutectique que l'on peut observer entre le gallium et le silicium,
- la face du substrat par laquelle les ions sont implantés est avantageusement mise en contact intime avec un raidisseur ; toutefois, celui-ci peut ne pas être utile, notamment lorsque la couche mince finalement obtenue est suffisamment rigide pour être autoportée,
- la mise en contact intime de la face du substrat avec le raidisseur est par exemple effectuée à une température inférieure à la température de fusion des précipités, ce qui évite notamment que la mise en contact intime se fasse à un moment où les précipités sont en phase liquide,
- la mise en contact intime est réalisée à la température ambiante, ce qui est, de même, particulièrement intéressant du point de vue énergétique,
- la mise en contact intime du substrat avec le raidisseur est réalisée par adhésion moléculaire, ce qui correspond à une technique de mise en contact intime bien connue et éprouvée ; un traitement thermique est avantageusement appliqué pour renforcer le collage, c'est-à-dire l'interface entre le substrat et le raidisseur ;
- la mise en contact intime peut aussi être obtenue par dépôt d'une couche suffisamment épaisse pour former ledit raidisseur,
- le dépôt de cette couche est avantageusement réalisé par épitaxie à partir du substrat, typiquement sur plusieurs centaines de microns (cette couche épitaxiée et le substrat sont donc avantageusement réalisés en des matériaux identiques ou au moins compatibles du point de vue réseau cristallin) ; dans ce cas, ce substrat est de préférence porté par un substrat porteur ayant un coefficient de dilatation thermique sensiblement différent de celui de la couche épitaxiée, auquel cas une variation de température, par exemple lors de la descente après le dépôt par épitaxie, provoque l'apparition de contraintes au niveau des précipités, ce qui favorise la rupture au niveau de ces précipités,
- la sollicitation de détachement est par exemple mécanique, ce qui permet un bon contrôle de son amplitude ; elle peut aussi être chimique (celle-ci peut profiter des contraintes générées par la présence des précipités ; en effet une attaque chimique sélective peut attaquer préférentiellement les zones contraintes du substrat),
- cette sollicitation de détachement est avantageusement sensiblement localisée au niveau de la couche de précipités en phase liquide, ce qui permet de ne pas solliciter le reste du substrat,
- la sollicitation de détachement localisée peut être réalisée par insertion d'une lame entre le substrat et le raidisseur, ce qui est une technique bien connue en soi,
- cette sollicitation de détachement peut être appliquée sous la forme d'efforts de traction appliqués au substrat et au raidisseur ; en variante il s'agit d'efforts de flexion, et/ou d'efforts de cisaillement, ce qui correspond également à des techniques bien connues en soi ; cette sollicitation peut aussi être appliquée au moyen d'ultrasons ou de micro-ondes de puissance et de fréquence appropriées,
- le raidisseur peut être réalisé dans le même matériau que celui qui constitue le substrat ; toutefois, ce raidisseur peut aussi être choisi en un matériau présentant un coefficient de dilatation sensiblement différent de celui du substrat, compte tenu des faibles températures que le procédé met en oeuvre,
- ce procédé comporte avantageusement, en outre, un traitement de finition appliqué à la face du film mince mis à nu par le détachement,
- ce procédé comporte avantageusement, en outre, des étapes, connues en soi, de fabrication de tout ou partie de composants micro-électroniques entre l'implantation et le détachement,
- ce procédé peut en outre comporter un traitement thermique, par exemple de recuit, propre à favoriser l'apparition des précipités suite à l'implantation (de préférence avant l'éventuelle mise en contact intime avec un raidisseur, pour minimiser la masse à porter à haute température ; mais ce traitement thermique peut aussi avoir lieu après cette mise en contact intime, auquel cas la formation des précipités se fait en plusieurs étapes).

Des objets, caractéristiques et avantages de l'invention ressortent de la description qui suit, donnée à titre d'exemple illustratif non limitatif en regard du dessin annexé sur lequel :
- la figure 1 est une vue schématique d'un substrat soumis à un bombardement d'ions, et à l'intérieur duquel est apparu une couche d'inclusions ou de précipités,
- la figure 2 est une vue schématique de ce substrat implanté et fragilisé, après collage d'un raidisseur, et
- la figure 3 est une vue schématique de l'ensemble de la figure 2, après application de sollicitations de détachement (sous la forme de contraintes mécaniques) à une température où les précipités sont liquides.

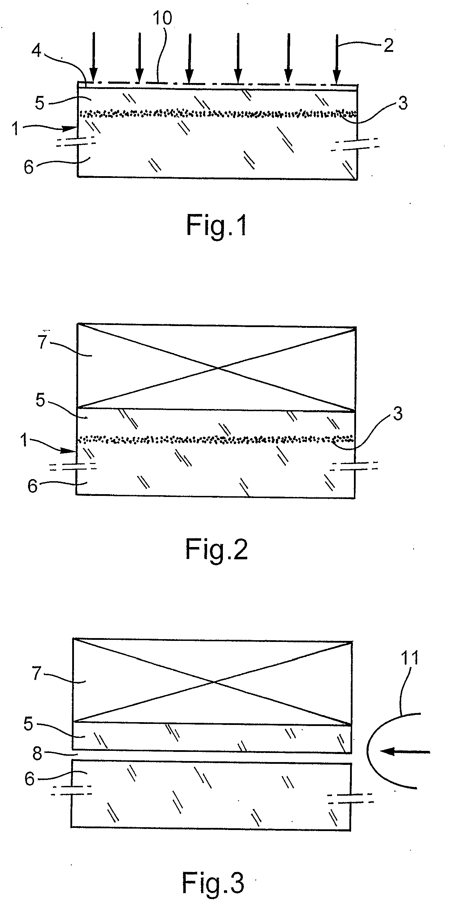

Les figures 1 à 3 représentent les principales étapes de mise en oeuvre du procédé conforme à l'invention.

La figure 1 représente un substrat 1 (parfois appelé plaquette), en principe réalisé en un matériau semi-conducteur, tel que du silicium.

Celui-ci est soumis à un bombardement d'ions schématisé par les flèches 2. La nature (c'est-à-dire l'espèce) de ces ions, non gazeuse, est choisie en fonction de la nature du substrat (formé d'une ou plusieurs espèces d'atomes), et les conditions d'implantation, c'est-à-dire de bombardement, (principalement la dose, l'énergie et la température) sont choisies de manière à créer des précipités confinés en profondeur, en sorte de permettre la formation d'une couche 3 de précipités (ou d'inclusions), ces précipités étant formés d'atomes implantés et éventuellement d'atomes du substrat. Ces précipités ont en outre la particularité d'être dans une première phase, à savoir solide, et d'avoir une température de fusion comprise dans (voire inférieure à) une gamme de températures considérée comme modérée dans la micro-électronique, et donc compatible avec le substrat. Cette température de fusion est avantageusement inférieure à 200 °C, voire même inférieure à 100 °C ou même encore inférieure à 50°C.

Ce bombardement est appliqué au travers d'une face supérieure 4 du substrat, éventuellement recouverte d'une couche 10, obtenue volontairement ou non, par exemple en oxyde.

Ce bombardement provoquant la formation des précipités peut s'accompagner d'un traitement thermique, conjoint ou postérieur, permettant la diffusion des atomes implantés jusqu'à former les précipités souhaités.

La couche de précipités 3 et la surface libre 4 délimitent le futur film mince 5 qu'on cherche à obtenir, tandis que le reste du substrat, sous cette couche 3, est désigné sous la référence 6. Ce film mince a typiquement une épaisseur de l'ordre du micron, voire inférieure au micron, voire même inférieure au dixième de micron.

Bien entendu les proportions dimensionnelles entre les diverses couches de la figure 2 ne sont pas conformes à la réalité, pour des raisons de lisibilité du dessin.

Dans l'exemple représenté à la figure 1, le substrat est massif c'est-à-dire qu'il forme l'ensemble de la pièce autoporteuse (telle qu'une plaquette) que l'on met en oeuvre. Ainsi que cela sera décrit ci-dessous, en variante, ce substrat n'est qu'une couche (portée par un support) au sein d'une pièce formée d'au moins deux couches (au moins la couche formant le substrat et une couche formant le support) en des matériaux en pratique différents, l'essentiel étant, pour la mise en oeuvre de l'invention, que la formation des précipités soit effectuée dans cette couche formant le substrat ; de préférence, le substrat est la couche supérieure de cette pièce multicouche (ce qui n'exclut pas qu'il puisse y avoir une couche très fine de revêtement telle que la couche 10 précitée).

A la figure 2, un substrat support 7 (optionnel), parfois aussi appelé raidisseur, est mis en contact intime avec le futur film mince ; il est ici collé, de préférence par adhésion moléculaire, à la surface libre 4 du substrat par laquelle le bombardement ionique a eu lieu. En variante, on peut réaliser ce raidisseur par dépôt sur le futur film mince par une quelconque technique connue de l'homme de métier (croissance en phase vapeur, par exemple, etc.). Ce raidisseur peut être réalisé dans le même matériau que le substrat de départ 1 (ou avoir ce matériau comme constituant essentiel : il peut par exemple s'agir d'un oxyde de l'espèce constituant le substrat). Il peut également être constitué d'un matériau présentant un coefficient de dilatation thermique différent de celui du substrat sous réserve que l'ensemble substrat/raidisseur soit compatible avec les traitements thermiques ultérieurs. En fait un tel raidisseur peut être omis si le film mince finalement obtenu a une épaisseur suffisante, notamment pour pouvoir être manipulé sans dégradation.

A la figure 3, à une température où les précipités formant la couche 3 sont en phase liquide (ce qui peut impliquer un traitement thermique à température modérée), une sollicitation de détachement, ici une concentration de contraintes, est appliquée de préférence au niveau de la couche de précipités. Cette application localisée de contraintes est ici obtenue au moyen d'une lame dont la pointe 11 est, compte tenu des dimensions du film mince (typiquement de l'ordre de quelques centièmes, voire de dixièmes de microns), à la fois en regard de l'interface entre les substrats et en regard de la couche de précipités. En variante cette application de contraintes mécaniques est obtenue par application d'efforts de traction et/ou de flexion et/ou de cisaillement, ainsi que cela est connu en soi dans le détachement de films minces ; cette application de contraintes de détachement peut aussi résulter de l'application d'ultra-sons ou de micro-ondes de puissance et de fréquences judicieusement choisies. En variante, cette sollicitation de détachement est une attaque chimique, par exemple une attaque sélective mettant par exemple à profit l'état contraint de la zone du substrat où s'est formée la couche de précipités.

Le passage des précipités de la phase solide à la phase liquide peut résulter de la simple application des sollicitations mécaniques et/ou chimiques. Sinon, la montée en température peut être simultanée à l'application de ces sollicitations ou intervenir avant celle-ci, en vue d'une bonne homogénéité en température, assurant que tous les précipités sont dans le même état.

Le détachement du film mince est avantageusement effectué à une température différente de la température d'implantation et de la température de collage, de manière à induire que les précipités changent de phase (solide vers liquide) au moment du détachement, et à ce moment seulement. En outre, le fait de pouvoir provoquer des changements successifs de phase (solide, puis liquide, puis solide, puis liquide, etc.) peut augmenter la fragilisation de la couche 3 par les précipités.

Toutefois, il est clair que, si les précipités sont liquides à la fin de l'implantation ou lors du collage, cela n'est pas rédhibitoire, dès lors qu'on n'applique pas de sollicitation excessive dans ces conditions (il faut alors prévoir des doses modérées d'implantation, de manière à éviter qu'un détachement intervienne pour une trop faible sollicitation notamment mécanique).

Compte tenu de ce que la couche de précipités est fragilisée par le fait que les précipités sont en phase liquide, cette application localisée de sollicitations mécaniques et/ou chimiques provoque la séparation de l'ensemble substrat/raidisseur jusqu'à leur détachement complet, avec l'apparition d'un espace 8 entre deux parties, à savoir le reste 6 du substrat de départ, et le raidisseur 7 auquel reste attaché le film mince 5.

On peut ensuite, de manière connue, appliquer un traitement de finition propre à conférer à la surface du film mince mise à nu par la séparation un état de surface approprié pour la suite de la mise en oeuvre de ce film mince.

Ce traitement de finition comporte par exemple un polissage mécanique classique suivi d'un traitement de recuit à haute température pour guérir les éventuels défauts structuraux pouvant exister dans le film mince.

Divers exemples dans le choix du substrat et des ions implantés, avec des conditions d'implantation appropriées, sont donnés ci-dessous.

### Exemple 1

Dans un premier temps, un substrat de silicium, par exemple monocristallin (mais il peut aussi s'agir d'un substrat polycristallin), est implanté avec des ions Ga⁺ dans les conditions suivantes :

| | |
|---|---|
| * énergie | 100 keV, |
| * dose | 10¹⁵ cm⁻² |

Cette implantation est réalisée sensiblement à la température ambiante.

La profondeur du pic de gallium ainsi obtenu est située à 75 nm sous la surface (cette valeur a pu être validée par des simulations sur le logiciel SRIM (c'est-à-dire Stopping and Range of Ions in Matter).

Le substrat est ensuite collé, par adhésion moléculaire, sur un substrat support, par exemple réalisé dans le même matériau que le substrat initial, ici du silicium. Cette mise en contact intime est réalisée sensiblement à la température ambiante.

Un traitement de recuit à 1100 °C pendant 10 s est ensuite appliqué à l'ensemble, ce qui contribue à renforcer l'interface entre les deux substrats ; on observe des précipités de gallium ou de type Ga₍₁₋ₓ₎Siₓ (voir les articles précités) localisés à la profondeur du pic de gallium. Ces précipités sont liquides au-delà d'un seuil de 30 °C et, dans ces conditions, fragilisent le substrat implanté.

L'application de contraintes mécaniques à une température supérieure à ce seuil (par exemple à 50 °C), c'est-à-dire à une température où les précipités sont liquides, par exemple par insertion d'une lame entre le substrat initial et le substrat formant raidisseur entraîne alors la séparation des deux substrats, non pas à l'emplacement de leur interface de collage moléculaire, mais au niveau des précipités liquides au sein du substrat initial : on obtient ainsi un film mince du premier substrat reporté sur le raidisseur (d'où le nom de substrat support).

Un détachement a aussi été obtenu par attaque chimique en mettant à profit le fait que le silicium est, à l'emplacement de la couche de précipités, contraint par la présence de ceux-ci. Or la gravure chimique dite « SECCO » est connue pour graver préférentiellement le silicium contraint. Une telle gravure, en combinaison avec l'application de contraintes mécaniques, en pratique en complément des précontraintes dues aux précipités, facilite donc le détachement.

Des traitements de finition de type polissage (classique ou chimique, recuits, notamment) sont ensuite appliqués pour éliminer les résidus de précipités, et obtenir un état de surface de bonne qualité.

On peut ensuite traiter le film mince selon les techniques connues dans les cas d'implantation d'ions gazeux.

Il peut y avoir, sur la face libre 4, des étapes de formation de tout ou partie de composants micro-électroniques, entre l'implantation et le détachement.

### Exemple 2

Un substrat en silicium, par exemple de mêmes caractéristiques que le substrat de départ de l'exemple 1, est implanté avec des ions Ga⁺ dans les conditions suivantes (sensiblement à la température ambiante) :

| | |
|---|---|
| * énergie | 100 keV |
| * dose | 10¹⁵ cm⁻² |

Cela correspond, comme dans l'exemple 1, à un pic de gallium à une profondeur de 75 nm dans le substrat.

Un recuit à 1100 °C pendant 10 s fait apparaître des précipités, comme dans l'exemple 1, localisés à une profondeur de 75 nm.

Le substrat est ensuite collé, par adhésion moléculaire, à un substrat support (à la différence de l'exemple 1 où ce collage est réalisé avant le traitement de recuit). Ce collage étant réalisé à une température inférieure à 30 °C, les précipités restent solides.

Comme dans l'exemple 1, l'application de contraintes mécaniques à une température supérieure à 30 °C (à 50 °C par exemple) par insertion d'une lame entre les deux substrats entraîne la rupture de l'ensemble au niveau des précipités dans le premier substrat, qui sont à l'état liquide.

On obtient ainsi, comme dans l'exemple 1, un film mince reporté sur un substrat support, et des traitements de finition (polissage, recuit, etc.) permettent d'éliminer les résidus de précipités et d'obtenir une bonne qualité de surface. Ce film mince peut, comme dans l'exemple 1, faire l'objet des traitements permettant l'utilisation du film mince.

### Exemple 3

Un substrat de silicium est implanté dans les mêmes conditions que dans l'exemple 1 (ou l'exemple 2), puis collé sur un substrat support et recuit pendant 10 s à 1100 °C, comme dans cet exemple 1.

Une série de cycles de température (par exemple une dizaine) autour de la température de fusion des précipités, c'est-à-dire autour de 30 °C, avec des variations de températures par exemple entre 20 °C (ou la température ambiante) et 40 °C, est ensuite appliqué : les précipités passent ainsi cycliquement d'une phase solide à une phase liquide et inversement, en changeant de volume (le gallium est plus dense à l'état liquide qu'à l'état solide), ce qui augmente localement la dégradation et donc la fragilisation de la couche du substrat dans laquelle les précipités sont concentrés.

L'application de contraintes mécaniques au dessus de 30 °C, comme dans les exemples précédents, vers 50 °C par exemple, entraîne alors la rupture de l'ensemble au niveau des précipités liquides. Toutefois, les contraintes mécaniques nécessaires à cette rupture sont plus faibles que dans les exemples 1 et 2 du fait de la dégradation supplémentaire induite par la série de cycles de température ; l'application des mêmes contraintes que dans ces exemples précédents conduit donc plus rapidement à la rupture.

On applique ensuite les mêmes traitements que précédemment, du point de vue finition puis du point de vue mise en oeuvre du film mince ainsi obtenu.

### Exemple 4

Un substrat, réalisé en nitrure de gallium GaN (sous phase würtzite, par exemple), est implanté avec des ions Ga⁺ dans les conditions suivantes (sensiblement à la température ambiante) :

| | |
|---|---|
| * énergie | 50 keV |
| * dose | 5.10¹⁶ cm⁻² |

On obtient ainsi des précipités de gallium solide (voir l'article précité de DHARA et al.), localisés à 24 nm de profondeur sous la surface d'implantation (y compris d'après des simulations en SRIM).

Compte tenu de ce que l'azote est une espèce gazeuse, il y a en outre des microcavités remplies de ce gaz.

En fait on peut appliquer une dose supérieure si l'on veut une plus grande quantité de précipités, de même nature, et à sensiblement la même profondeur.

Le substrat en GaN est ensuite collé par adhésion moléculaire sur un substrat support, par exemple un substrat en saphir, la température des étapes impliquées par le collage restant inférieures à 30 °C, de manière à ce que les précipités restent solides pendant toute l'opération de collage.

Un traitement thermique comportant une étape à plus de 30 °C (à 50 °C par exemple) est ensuite appliqué à l'ensemble, ce qui entraîne le changement de phase des précipités qui deviennent liquides, et fragilisent le substrat au niveau de la couche dans laquelle ils sont concentrés.

L'application de contraintes mécaniques à une température supérieure à 30 °C, par insertion d'une lame comme dans les exemples précédents, provoque la séparation des deux substrats au niveau où sont concentrés les précipités liquides.

On obtient ainsi un film mince de GaN qui peut ensuite faire l'objet de tous les traitements de finition et de mise en oeuvre appropriés.

### Exemple 5

On part d'un pièce formée d'un substrat porteur en saphir (en variante il peut s'agir d'un autre matériau différent du GaN) portant une couche de GaN de quelques microns ; le substrat, au sens de la description qui précède, est donc ici formé de cette couche en GaN. Après formation, dans cette couche, de précipités par bombardement (assisté ou non d'un traitement thermique), par exemple selon les données de l'exemple précédent, on procède à une reprise d'épitaxie de GaN (épitaxie, typiquement réalisée entre 800°C et 1100°C) sur plusieurs centaines de microns. Les précipités sont liquides à la température d'épitaxie. Lors de la descente en température, une fracture peut être obtenue au niveau de la zone des précipités (toujours à l'état liquide) du fait de la différence de coefficient de dilatation thermique entre le matériau du substrat porteur (ici le saphir) et de celui du matériau épitaxié (induisant des contraintes au niveau de la structure), éventuellement en combinaison avec l'application d'une contrainte mécanique extérieure. Après cette fracture, on obtient un substrat massif en GaN formé du matériau épitaxié et de la partie du substrat de départ situé au dessus de la zone de précipités.

Cet exemple montre l'intérêt qu'il peut y avoir à introduire des espèces présentant des points de fusion élevés.

D'autres couples de matériaux peuvent être mis en oeuvre selon l'invention. C'est ainsi que divers exemples d'atomes susceptibles de faire l'objet d'une implantation ionique sont indiqués ci-dessous (y compris le gallium) avec leur température de fusion (selon les besoins, on peut préférer des éléments à bas point de fusion (typiquement inférieur à de l'ordre de 200°C ou au contraire préférer des éléments ayant des points de fusion plus élevés) :

| | |
|---|---|
| - mercure | -38.87 °C |
| - césium | 28.5 °C |
| - gallium | 29.8 °C |
| - rubidium | 38.89 °C |
| - phosphore | 44.2°C (non métallique) |
| - potassium | 63.25 °C |
| - sodium | 97.8 °C |
| - soufre | 119.°C (non métallique) |
| - indium | 156.6 °C |
| - lithium | 180.5 °C |
| - étain | 231.9°C |
| - thallium | 303.5°C |
| - zinc | 419.5°C |
| - tellure | 450°C |
| - magnésium | 649°C |
| - aluminium | 660.4°C |
| - cérium | 799°C |
| - calcium | 839°C |
| - germanium | 937.4°C (non métallique) |
| - argent | 961.9 °C. |

Ces atomes peuvent notamment être implantés dans des substrats massifs ou non, cristallins ou non, semi-conducteurs ou non, en silicium ou en un matériau à base de silicium (par exemple, oxyde de silicium, voire carbure de silicium ou nitrure de silicium), voire dans d'autres matériaux utilisés dans la micro-électronique (GaN - voir ci-dessus, GaAs, a-Si :H, diamant, saphir, notamment, voire le germanium et ses alliages avec le silicium), voire en un matériau du groupe III-V ou du groupe III-N ou encore du groupe II-VI.

Ainsi que cela est connu en soi, divers traitements peuvent être appliqués, entre les étapes du procédé décrit aux figures 1 à 3, en vue de fabriquer tout ou partie de composants micro-électroniques, à la surface libre du substrat, avant mise en contact intime avec le raidisseur.

## Revendications

1. Procédé de fabrication d'un film mince à partir d'un substrat comportant les étapes suivantes :
- implantation dans le substrat d'ions d'une espèce non gazeuse, cette espèce et les conditions d'implantation étant choisies, en fonction du matériau du substrat, en sorte de permettre la formation de précipités formés d'atomes implantés et éventuellement d'atomes du substrat et confinés en profondeur et répartis au sein d'une couche, ces précipités étant en une phase solide ayant une température de fusion inférieure à celle du substrat;
- mise en contact intime de la face du substrat par laquelle les ions sont implantés avec un raidisseur ; et
- passage des précipités de la phase solide à la phase liquide et détachement d'un film mince par rupture du substrat au niveau de la couche de précipités par l'application d'une sollicitation de détachement dans des conditions où les précipités sont en phase liquide.

2. Procédé selon la revendication 1, **caractérisé en ce que** l'implantation des ions est réalisée à une température inférieure à la température de fusion des précipités.

3. Procédé selon la revendication 1, **caractérisé en ce que** la température de fusion des précipités est supérieure à la température ambiante et l'implantation est effectuée sensiblement à la température ambiante.

4. Procédé selon l'une quelconque des revendications 1 à 3, **caractérisé en ce que** le détachement est précédé d'une pluralité de cycles consistant à faire varier la température du substrat contenant les précipités de part et d'autre de la température de fusion de ceux-ci.

5. Procédé selon l'une quelconque des revendications 1 à 4, **caractérisé en ce que** les ions sont choisis au sein du groupe comportant le césium, le gallium, le rubidium, le potassium, le sodium, l'indium et le lithium.

6. Procédé selon l'une quelconque des revendications 1 à 5, **caractérisé en ce que** le substrat est une couche portée par un substrat porteur.

7. Procédé selon l'une quelconque des revendications 1 à 6, **caractérisé en ce que** les ions sont des ions gallium et le substrat est en silicium, les ions étant implantés avec une énergie d'au moins environ 100 keV, avec une dose d'au moins 10¹⁵ /cm².

8. Procédé selon l'une quelconque des revendications 1 à 7, **caractérisé en ce que** le substrat est en nitrure de gallium et le substrat est en un matériau du groupe III-V, du groupe III-N ou du groupe II-VI.

9. Procédé selon l'une des revendications 1 à 6, **caractérisé en ce que** les ions sont des ions gallium et le substrat est en nitrure de gallium, ces ions étant implantés avec une énergie d'au moins environ 50 keV, avec une dose d'au moins 10¹⁵ /cm².

10. Procédé selon l'une quelconque des revendications 1 à 9, **caractérisé en ce que** les précipités sont essentiellement constitués de l'espèce implantée dans le substrat.

11. Procédé selon l'une quelconque des revendications 1 à 10, **caractérisé en ce que** la mise en contact intime est réalisée à la température ambiante.

12. Procédé selon l'une quelconque des revendications 1 à 11, **caractérisé en ce que** la mise en contact intime du substrat avec le raidisseur est réalisé par adhésion moléculaire.

13. Procédé selon l'une quelconque des revendications 1 à 12, **caractérisé en ce que** la mise en contact intime est obtenue par dépôt d'une couche suffisamment épaisse pour former ledit raidisseur.

14. Procédé selon l'une quelconque des revendications 1 à 13, **caractérisé en ce que** la sollicitation de détachement est mécanique et/ou chimique.

15. Procédé selon la revendication 14, **caractérisé en ce que** cette sollicitation de détachement est sensiblement localisée au niveau de la couche de précipités en phase liquide.

## Patentansprüche

1. Verfahren zum Herstellen eines Dünnfilms ausgehend von einem Substrat, umfassend die folgenden Schritte:
- Implantieren von Ionen einer nicht gasförmigen Spezies in das Substrat, wobei die Spezies und die Implantierungsbedingungen in Abhängigkeit von dem Substratmaterial derart ausgewählt werden, um das Bilden von Präzipitaten, die aus implantierten Atomen und gegebenenfalls aus Atomen des Substrats gebildet sind und in der Tiefe begrenzt und innerhalb einer Schicht verteilt sind, zu ermöglichen, wobei diese Präzipitaten in einer festen Phase sind, die eine Schmelztemperatur aufweist, die niedriger als jene des Substrats ist;
- enges Inkontaktbringen der Fläche des Substrats, durch die die Ionen mit einem Versteifer implantiert werden; und
- Übergang der Präzipitaten von der festen Phase in die flüssige Phase und Ablösen eines Dünnfilms durch Brechen des Substrats an der Schicht der Präzipitaten durch Aufbringen von einer Ablösungsbeanspruchung unter Bedingungen, bei denen die Präzipitaten in der flüssigen Phase sind.

2. Verfahren nach Anspruch 1, **dadurch gekennzeichnet, dass** das Implantieren der Ionen bei einer Temperatur durchgeführt wird, die niedriger als die Schmelztemperatur der Präzipitaten ist.

3. Verfahren nach Anspruch 1, **dadurch gekennzeichnet, dass** die Schmelztemperatur der Präzipitaten höher als die Umgebungstemperatur ist und das Implantieren im Wesentlichen bei der Umgebungstemperatur durchgeführt wird.

4. Verfahren nach einem der Ansprüche 1 bis 3, **dadurch gekennzeichnet, dass** dem Ablösen mehrere Zyklen vorausgehen, die darin bestehen, die Temperatur des Substrats, das die Präzipitaten enthält, beiderseits der Schmelztemperatur von diesen zu ändern.

5. Verfahren nach einem der Ansprüche 1 bis 4, **dadurch gekennzeichnet, dass** die Ionen aus der Gruppe ausgewählt werden, die Cäsium, Gallium, Rubidium, Kalium, Natrium, Indium und Lithium umfasst.

6. Verfahren nach einem der Ansprüche 1 bis 5, **dadurch gekennzeichnet, dass** das Substrat eine Schicht ist, die von einem Trägersubstrat getragen wird.

7. Verfahren nach einem der Ansprüche 1 bis 6, **dadurch gekennzeichnet, dass** die Ionen Gallium-Ionen sind und das Substrat aus Silizium ist, wobei die Ionen mit einer Energie von mindestens ungefähr 100 keV mit einer Dosis von mindestens 10¹⁵ Ionen/cm² implantiert werden.

8. Verfahren nach einem der Ansprüche 1 bis 7, **dadurch gekennzeichnet, dass** das Substrat aus Galliumnitrid ist und das Substrat aus einem Material der Gruppe III-V, der Gruppe III-N oder der Gruppe II-VI ist.

9. Verfahren nach einem der Ansprüche 1 bis 6, **dadurch gekennzeichnet, dass** die Ionen Gallium-Ionen sind und das Substrat aus Galliumnitrid ist, wobei diese Ionen mit einer Energie von mindestens ungefähr 50 keV mit einer Dosis von mindestens 10¹⁵ Ionen/cm² implantiert werden.

10. Verfahren nach einem der Ansprüche 1 bis 9, **dadurch gekennzeichnet, dass** die Präzipitaten im Wesentlichen aus der Spezies gebildet werden, die in das Substrat implantiert wird.

11. Verfahren nach einem der Ansprüche 1 bis 10, **dadurch gekennzeichnet, dass** das enge Inkontaktbringen bei der Umgebungstemperatur durchgeführt wird.

12. Verfahren nach einem der Ansprüche 1 bis 11, **dadurch gekennzeichnet, dass** das enge Inkontaktbringen des Substrats mit dem Versteifer durch molekulare Adhäsion durchgeführt wird.

13. Verfahren nach einem der Ansprüche 1 bis 12, **dadurch gekennzeichnet, dass** das enge Inkontaktbringen durch Abscheiden einer Schicht erhalten wird, die ausreichend dick ist, um den Versteifer zu bilden.

14. Verfahren nach einem der Ansprüche 1 bis 13, **dadurch gekennzeichnet, dass** die Ablösungsbeanspruchung mechanisch und/oder chemisch ist.

15. Verfahren nach Anspruch 14, **dadurch gekennzeichnet, dass** diese Ablösungsbeanspruchung im Wesentlichen auf der Ebene der Schicht der Präzipitaten in flüssiger Phase lokalisiert wird.

## Claims

1. Method of fabricating a thin film from a substrate, including the following steps:
- implanting in the substrate ions of a non-gaseous species, that species and the implantation conditions being chosen as a function of the material of the substrate so as to enable the formation of precipitates formed from implanted atoms and optionally from atoms of the substrate, confined in depth and distributed within a layer, those precipitates being in a solid phase having a melting point below that of the substrate;
- bringing the face of the substrate through which the ions are implanted into intimate contact with a stiffener; and
- passing the precipitates from the solid phase to the liquid phase and detaching a thin film by breaking the substrate at the level of the layer of precipitates by applying a detachment stress under conditions in which the precipitates are in the liquid phase.

2. Method according to Claim 1, **characterized in that** the implantation of the ions is effected at a temperature below the melting point of the precipitates.

3. Method according to Claim 1, **characterized in that** the melting point of the precipitates is above room temperature and the implantation is carried out substantially at room temperature.

4. Method according to any one of Claims 1 to 3, **characterized in that** the detachment is preceded by a plurality of cycles that vary the temperature of the substrate containing the precipitates on either side of the melting point thereof.

5. Method according to any one of Claims 1 to 4, **characterized in that** the ions are chosen within the group comprising cesium, gallium, rubidium, potassium, sodium, indium and lithium.

6. Method according to any one of Claims 1 to 5, **characterized in that** the substrate is a layer carried by a support substrate.

7. Method according to any one of Claims 1 to 6, **characterized in that** the ions are gallium ions and the substrate is in silicon, the ions being implanted at an energy of at least approximately 100 keV and a dose of at least 10¹⁵/cm².

8. Method according to any one of Claims 1 to 7, **characterized in that** the substrate is in gallium nitride and the substrate is in a material from group III-V, from group III-N or from group II-VI.

9. Method according to one of Claims 1 to 6, **characterized in that** the ions are gallium ions and the substrate is in gallium nitride, these ions being implanted at an energy of at least approximately 50 keV and a dose of at least 10¹⁵ /cm².

10. Method according to any one of claims 1 to 9, **characterized in that** the precipitates consist essentially of the species implanted in the substrate.

11. Method according to any one of Claims 1 to 10, **characterized in that** the bringing into intimate contact is effected at room temperature.

12. Method according to any one of Claims 1 to 11, **characterized in that** the bringing of the substrate into intimate contact with the stiffener is effected by molecular adhesion.

13. Method according to any one of Claims 1 to 12, **characterized in that** the bringing into intimate contact is achieved by depositing a layer sufficiently thick to form said stiffener.

14. Method according to any one of Claims 1 to 13, **characterized in that** the detachment stress is mechanical and/or chemical.

15. Method according to Claim 14, **characterized in that** this detachment stress is substantially localized at the level of the layer of precipitates in the liquid phase.
